# EUROPEAN PATENT APPLICATION

(11) **EP 0 658 917 A2**
(43) Date of publication of application: **21.06.1995**
(21) Application number: 94119595.0
(22) Date of filing: 12.12.1994
(51) Int. Cl.: H01J 37/305, H01L 21/306

(54) **Fine-processing apparatus using low-energy neutral particle beam**

(30) Priority: 14.12.1993 JP 342496/93
(71) Applicant: EBARA CORPORATION, Ohta-ku, Tokyo (JP)
(72) Inventor: Nishimura, Tatsuya, c/o Ebara Res. Co., Ltd., Fujisawa-shi, Kanagawa-ken (JP); Suzuki, Hidenao, c/o Ebara Res. Co., Ltd., Fujisawa-shi, Kanagawa-ken (JP)
(74) Representative: Wagner, Karl H., Dipl.-Ing.

(57) **Abstract**

A fine-processing apparatus using a low-energy neutral particle beam is disclosed. The apparatus comprises a plasma chamber for generating a high-density plasma therein, an electrode for drawing out a low-energy ion beam from the plasma chamber, a neutralizing chamber in which a reactive gas is introduced so as to contact the ion beam to neutralize the ion beam through charge exchange and produce a neutral particle beam, and regulating means for aligning the direction of motion of the neutral particle beam produced in the neutralizing chamber toward an object to be processed. The fine processing is effected by assist of bombardment with the low-energy neutral particle beam simultaneously with a reaction of the reactive gas adsorbed on the surface of the object to be processed.

## Description

The present invention relates to a fine-processing apparatus using a low-energy neutral particle beam in microfabrication technology that can be applied to the production of semiconductor devices, micromachining or the like. More particularly, the present invention relates to a fine-processing apparatus wherein a low-energy neutral particle beam and a reactive gas are simultaneously applied to an object to be processed, i.e., workpiece, thereby effecting fine processing precisely to realize a line width of not greater than 0.3 µm, for example, while minimizing damage to the workpiece.

In fine processing of semiconductor devices, etc., dry etching that uses plasma or charged particles, e.g., ions, is now generally employed as a leading etching technique. With the development of the dry etching technique, the degree of integration of semiconductor devices has increased, and circuit patterns have been demanded to be made finer. As a result, the following problems have arisen with respect to the conventional dry etching method using plasma or charged particles.

First, the electric charge carried by charged particles causes the surface of the workpiece to become charged. As a result, the orbit of the following charged particles is deflected, so that it becomes impossible to perform processing of high accuracy.

Secondly, with the achievement of reduction in pattern size in the horizontal direction, the thickness of an insulating layer such as an oxide film has also become thin. Therefore, breakdown of such an insulating layer is likely to occur owing to the charging of the workpiece surface caused by the charged particles.

Thirdly, the surface of the workpiece may be damaged by high energy charged particles.

These are serious problems that hinder improvement in the degree of integration of devices.

Although a great variety of methods have been attempted to solve the above-described problems, it is impossible to fundamentally solve the problems as long as charged particles are used for fine processing. Under these circumstances, examination has recently started with regard to fine processing employing neutral particles. For example, there is a method of forming a neutral particle beam by jetting out heated gas molecules from a nozzle. However, this method has disadvantages in that since gas molecules are heated, reaction of the furnace material with the gas molecules gives rise to a serious problem, and that it is difficult to obtain a neutral particle beam of large diameter.

Further, a neutral particle beam generation source using ECR electric discharge that utilizes microwave resonance and a magnetic field has recently been reported. This apparatus suffers, however, from some problems. Namely, since ECR electric discharge needs a high magnetic field intensity, the apparatus becomes large in size. Further, it is necessary in order to produce a uniform plasma to dispose a plurality of magnetic fields. As a result, the apparatus becomes complicated. Further, the conventional ECR apparatus involves the problem that since the degree of ionization in the plasma is high, ions are also emitted together with neutral particles, and the emitted neutral particles do not have a uniform direction.

In view of the above-described problems of the prior art, it is an object of the present invention to provide a fine-processing apparatus which generates a high-density, low-energy and high-directivity neutral particle beam and enables fine processing by synergistic effect of the neutral particle beam and a reactive gas, thereby realizing a microfabrication technique useful for the production of next-generation or more future semiconductor devices and for micromachining.

To attain the above-described object, a fine-processing apparatus according to the present invention includes a plasma chamber for generating a high-density plasma; an electrode for drawing out a low-energy ion beam from the plasma chamber; a neutralizing chamber in which a reactive gas is introduced so as to contact the ion beam to neutralize the ion beam through charge exchange and produce a neutral particle beam; and regulating means for aligning the direction of motion of the neutral particle beam produced in the neutralizing chamber toward an object to be processed.

According to the present invention having the above-described arrangement, only an ion component is effectively drawn out from the high-density plasma generated by electric discharge, and the ion component is neutralized to form a beam of neutral particles which have a uniform direction of motion. Thus, fine processing is realized by synergistic effect by bombardment with the neutral particle beam and reaction of a reactive gas on the surface of the object to be processed.

The neutral particle beam generating source is composed of a means for generating a high-density plasma, and a means for drawing out ions from the plasma and electrically neutralizing them to form a neutral particle beam. In the above-described arrangement, the generation of a high-density plasma may be effected in the plasma chamber by employing hot-filament discharge, hollow cathode discharge, LaB₆ cathode discharge, high-frequency discharge, or microwave discharge.

The space potential of the plasma generated by these methods is preferably about several tens of V. Further, the plasma chamber is provided with a gas inlet port so that a gas for electric discharge can be supplied into the plasma chamber.

The electrode for drawing out a low-energy ion beam from the plasma chamber may be provided at the outlet of the plasma chamber and is placed at negative potential.

A shielding electrode for shielding the plasma within the plasma chamber, which is electrically floated, may be provided inside of the drawing out electrode at the outlet of the plasma chamber.

The regulating means may be an electrode which is provided outside of the drawing out electrode at the outlet of the plasma chamber and is maintained at the ground potential. The neutralizing chamber may be defined by a space between the drawing out electrode and the regulating electrode and the reactive gas, typically a halogencontaining reactive gas is supplied to the neutralizing chamber. Instead, an inert gas and/or a reactive gas may be supplied to the neutralizing chamber.

Preferably, the drawing out electrode, the regulating electrode and the shielding electrode respectively are discshaped electrode including a great number of pores.

The object to be processed may be installed on a sample table which is installed in a vacuum container provided adjacent to the neutralizing chamber.

The sample table may be communicated with a cooling means for cooling the object to be processed to a predetermined temperature so that the reactive gas is adsorbed on the surface of the object. In addition the sample table may be rotated by a motor for uniformly bombarding the surface of the object with the neutral particle beam.

The above and other objects, features and advantages of the present invention will become more apparent from the following description when taken in conjunction with the accompanying drawings in which a preferred embodiment of the present invention is shown by way of illustrative examples.
Fig. 1 is a schematic sectional view showing one embodiment of the fine-processing apparatus using a low-energy neutral particle beam according to the present invention;
Fig. 2 is a detailed sectional view of a portion of the apparatus shown in Fig. 1;
Fig. 3 is an enlarged view of an essential part of the embodiment shown in Fig. 1.
Figs. 4(a) and 4(b) are detailed views of a shielding electrode and a drawing electrode; and
Figs. 5(a) and 5(b) are detailed views of a regulating electrode.

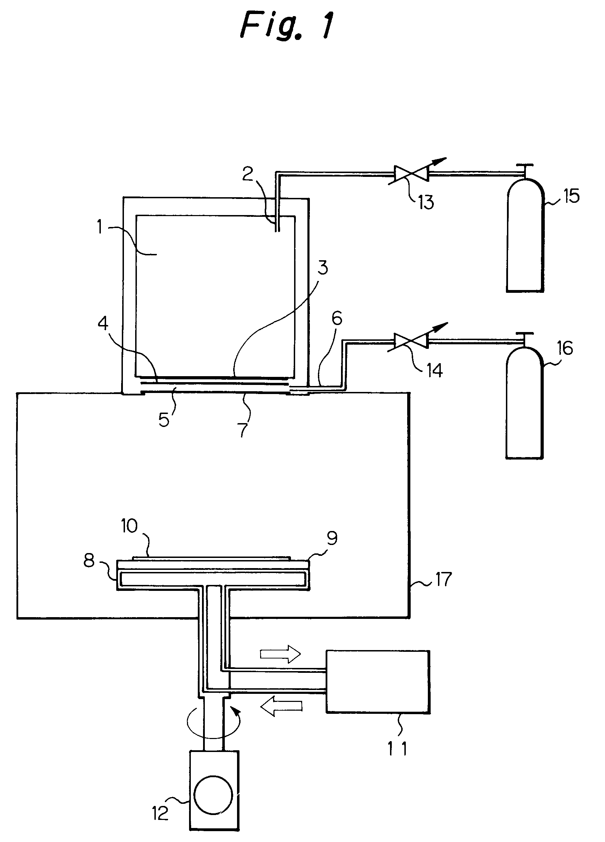

One embodiment of the fine-processing apparatus using a low-energy neutral particle beam according to the present invention will be described below with reference to Figs. 1 to 5.

Fig. 1 shows the general arrangement of the fine-processing apparatus according to one embodiment of the invention. In Fig. 1, reference numeral 1 denotes a plasma chamber. A gas inlet port 2 opens in the plasma chamber 1. The gas inlet port 2 is connected to a gas cylinder 15 for electric discharge through a flow control valve 13.

Reference numeral 3 denotes a shielding electrode. A drawing electrode 4 is installed at a position adjacent to the shielding electrode 3. Further, a regulating electrode 7 is installed adjacently to the drawing electrode 4.

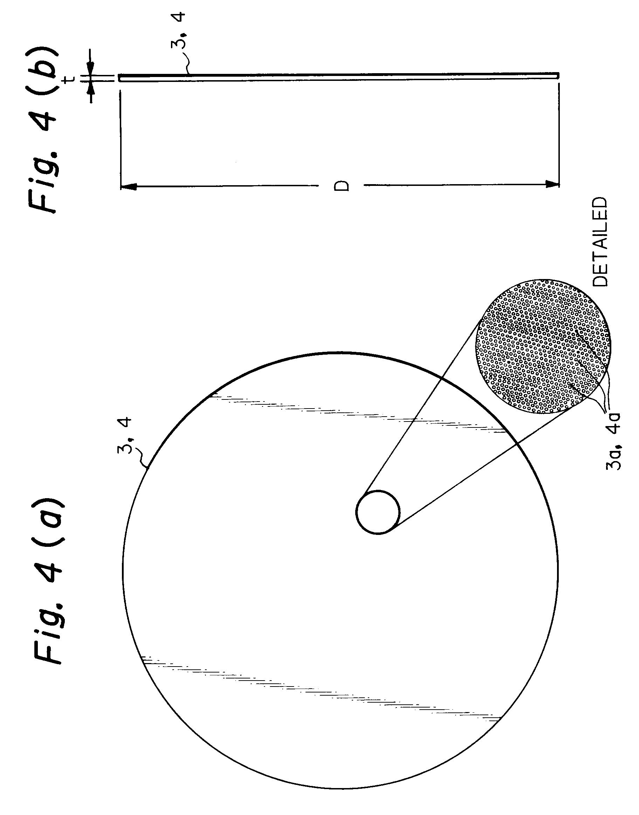

Fig. 4 (Fig. 4(a) is a front view, and Fig. 4(b) is a side view) shows the structure of each of the shielding and drawing electrodes 3 and 4. In this embodiment, these electrodes are disc-shaped electrodes having a diameter D of 200 mm and a thickness t of 0.5 mm, which are formed with a great number of pores 3a and 4a.

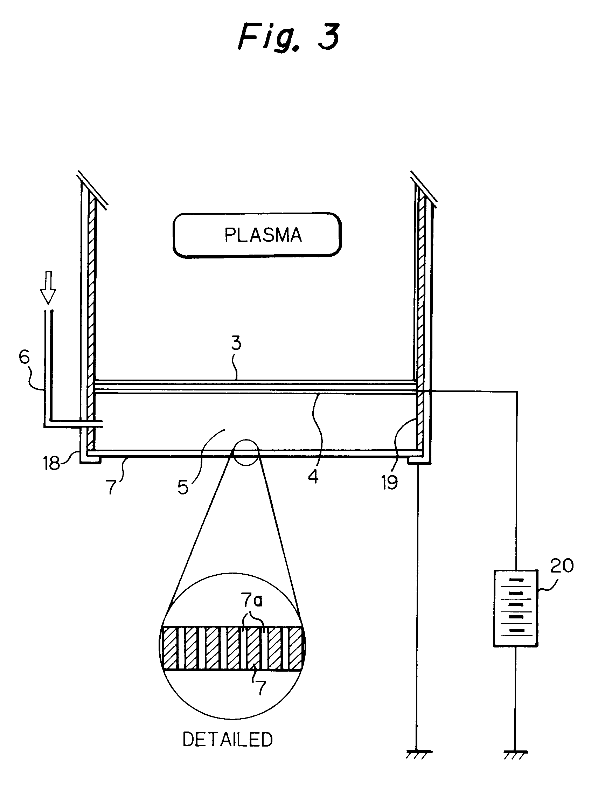

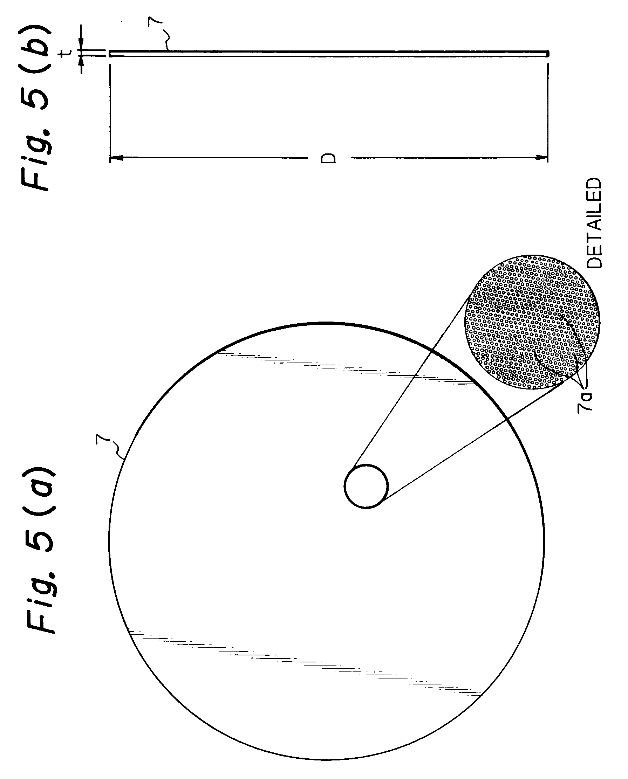

Fig. 5 (Fig. 5(a) is a front view, and Fig. 5(b) is a side view) shows the structure of the regulating electrode 7. In this embodiment, the regulating electrode 7 is a disc-shaped electrode having a diameter D of 200 mm and a thickness t of 1 mm, which is formed with a great number of pores 7a (see Fig. 3). A neutralizing chamber 5 is defined between the drawing electrode 4 and the regulating electrode 7. The ratio of a length to a diameter of each pore 7a is large enough to regulate the direction of the motion of neutral particle beam emitting from the neutralizing chamber 5 toward an object to be processed as will be explained later. A reactive gas inlet port 6 opens in the neutralizing chamber 5. The reactive gas inlet port 6 is connected to a reactive gas cylinder 16 through a flow control valve 14.

A sample table 8 is installed in a vacuum container 17. An electrostatic chuck 9 is installed on the sample table 8 to hold a workpiece 10 (i.e., an object to be processed) in close contact with the sample table 8. The inside of the sample table 8 is communicated with a refrigerant circulating device 11 incorporating a temperature control circuit so that the sample table 8 can be cooled down from ordinary temperatures to about -200°C, thereby enabling the temperature of the workpiece 10 to be maintained at a constant level in the above-mentioned temperature range to adsorb the reactive gas particles on the workpiece surface. Further, the sample table 8 can be rotated at a constant speed by a motor 12 so that a neutral particle beam can be uniformly applied to the workpiece 10.

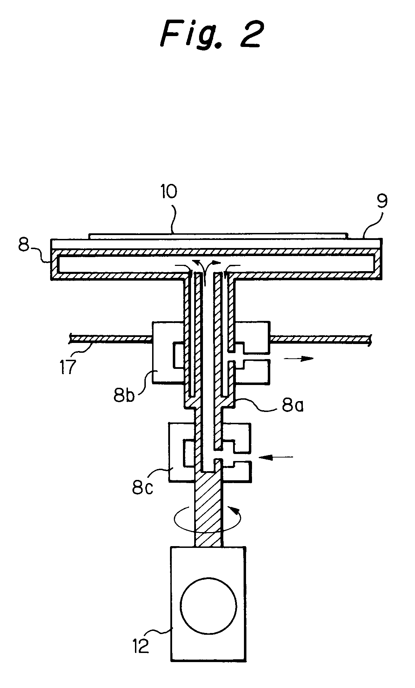

To this end, the shaft 8a of the sample table 8 has a double shell structure as shown in Fig. 2 and is sealingly and rotatably supported by a pair of bearing members 8b, 8c and a refrigerant is circulated through the shaft 8a and the sample table 8 as indicated by the arrows.

Fig. 3 shows the positional relationship and potential relationship between the shielding electrode 3, the drawing electrode 4 and the regulating electrode 7. In Fig. 3, reference numeral 18 denotes a casing. The casing 18 is grounded. The casing 18 has an insulating material 19 disposed on the inner wall thereof. The drawing electrode 4 is connected to a power supply 20 for providing a negative potential thereto.

Next, the operation of the fine-processing apparatus, arranged as described above, will be explained.

A gas for electric discharge is supplied into the plasma chamber 1 from the gas cylinder 15 for electric discharge through the flow control valve 13, and a high-density plasma is generated in the plasma chamber 1 by one of the above-described plasma generating methods. In this case, the gas that is supplied into the plasma chamber 1 is a halogen-containing reactive gas or an inert gas such as Ar gas.

When a high-density plasma is generated, the shielding electrode 3 is brought into an electrically floating state since it is in contact only with the plasma. At this time, an ion sheath is formed on the surface of the shielding electrode 3, which is in contact with the plasma, and, therefore, the plasma is shielded from flowing out of the plasma chamber 1. At the same time, a negative voltage is applied to the drawing electrode 4, and thus only an ion component is drawn out from the shielded plasma. At this time, the ion component is accelerated to the level of energy that is determined by the difference between the space potential of the plasma and the negative potential applied to the drawing electrode 4. Thus, the ion component enters the neutralizing chamber 5 in the form of a beam of ions which are uniform in the direction of motion. In this case, the energy of the ion beam can be varied by changing the voltage applied to the drawing electrode 4.

The ion beam entering the neutralizing chamber 5 collides with a reactive gas supplied from the reactive gas cylinder 16 through the reactive gas inlet port 6 via the flow control valve 14 and performs charge exchange with the reactive gas to become a neutral particle beam while maintaining the kinetic energy. Then, the neutral particle beam passes through the regulating electrode 7 maintained at the ground potential. As the regulating electrode 7 is maintained at the ground potential, the charge-up of the electrode is prevented and thereby the neutralization rate of the ion beam may be increased. When the neutral particle beam passes through the regulating electrode 7, direction of motion of the neutral particles are aligned by the pores in the electrode 7, so that only a neutral particle beam having a rectilinear movement component toward the object is emitted from the neutral particle beam source, i.e., neutralizing chamber.

Thus, a low-energy and high-directivity neutral particle beam can be obtained. The reactive gas that performs charge exchange with the ion beam becomes ions having a velocity of the order of thermal velocity, which then recombines with secondary electrons in the vicinity of the regulating electrode 7 to become a neutral gas or radicals. These reactive gases arrive at the surface of the cooled workpiece 10 on the sample table 8, which is installed outside the neutral particle beam source, causing a surface adsorption and reaction to form a reaction product. Since this is a weak chemical reaction, the resulting reaction product can hardly be desorbed from the workpiece surface. However, since the neutral particle beam having kinetic energy is applied to the workpiece 10 at the same time as the reaction product is formed, the reaction on the surface of the workpiece is promoted and, thus the reaction product is desorbed from the workpiece surface by bombardment with the neutral particle beam. In this way, the adsorption and reaction of the neutral gas and radicals with the cooled workpiece surface and the subsequent surface bombardment with the neutral particle beam occur repeatedly, and thus etching proceeds.

As has been described above, according to the present invention, a low-energy ion beam is drawn out from a high-density plasma source and neutralized in the neutralizing chamber by supplying a reactive gas, thereby effectively generating a low-energy beam of neutral particles which are uniform in the direction of motion. Moreover, the supplied reactive gas is positively adsorbed on the surface of the workpiece, thereby enabling etching to proceed by synergistic effect of the surface adsorption of the reactive gas and the surface bombardment with the neutral particle beam having kinetic energy.

In this method, since etching proceeds with the aid of bombardment with neutral particles, the workpiece surface can be prevented from being charged. Accordingly, it is possible to overcome problems such as malformation or dielectric breakdown, which may occur when a plasma or charged particles are used. Thus, fine processing can be realized. Further, since the energy of the neutral particle beam can be controlled to a level not higher than about 100 eV, damage to the workpiece can be minimized.

It should be noted that the objects and advantages of the invention may be attained by means of any compatible combination(s) particularly pointed out in the items of the following summary of the invention and the appended claims.

### The invention may be summarized as follows:

1. A fine-processing apparatus using a low-energy neutral particle beam, comprising:
   a plasma chamber for generating a high-density plasma therein;
   an electrode for drawing out a low-energy ion beam from said plasma chamber;
   a neutralizing chamber in which a reactive gas is introduced so as to contact said ion beam to neutralize said ion beam through charge exchange and produce a neutral particle beam; and
   regulating means for aligning the direction of motion of said neutral particle beam produced in said neutralizing chamber toward an object to be processed.
2. A fine-processing apparatus particularly as defined in 1, wherein said high-density plasma is generated by hot-filament discharge, hollow cathode discharge, LaB₆ cathode discharge, high-frequency discharge, or microwave discharge.
3. A fine-processing apparatus according to Claim 2, wherein a space potential of said plasma generated in said plasma chamber is about several tens of volt.
4. A fine-processing apparatus particularly as defined in 2, wherein said plasma is generated by discharging a halogencontaining reactive gas or an inert gas supplied into said plasma chamber.
5. A fine-processing apparatus particularly as defined in 1, wherein said reactive gas is a halogen-containing gas.
6. A fine-processing apparatus according to Claim 1, wherein the energy level of said neutral particle beam is less than 100 eV.
7. A fine-processing apparatus particularly as defined in 5, wherein said fine processing is an etching which is effected by assist of bombardment with said low-energy neutral particle beam simultaneously with a reaction of said halogen-containing reactive gas adsorbed on the surface of said object to be processed.
8. A fine-processing apparatus particularly as defined in 1, wherein said drawing out electrode is provided at the outlet of said plasma chamber and is placed at negative potential.
9. A fine-processing apparatus according to Claim 8, wherein said drawing out electrode is a disc-shaped electrode including a number of pores.
10. A fine-processing apparatus particularly as defined in 1, wherein a shielding electrode for shielding said plasma within said plasma chamber is provided inside of said drawing out electrode at the outlet of said plasma chamber.
11. A fine-processing apparatus according to Claim 10, wherein said shielding electrode is an electrically floating electrode.
12. A fine-processing apparatus particularly as defined in 10, wherein said shielding electrode is a disc-shaped electrode including a number of pores.
13. A fine-processing apparatus particularly as defined in 1, wherein said regulating means is an electrode provided outside of said drawing out electrode at the outlet of said plasma chamber, and said neutralizing chamber is defined between said drawing out electrode and said regulating electrode.
14. A fine-processing apparatus particularly as defined in 13, wherein said regulating electrode is maintained at the ground potential.
15. A fine-processing apparatus particularly as defined in 13, wherein said regulating electrode is a disc-shaped electrode including a number of pores.
16. A fine-processing apparatus particularly as defined in 1, wherein said object to be processed is installed in a vacuum container provided adjacent to said neutralizing chamber.
17. A fine-processing apparatus particularly as defined in 16, wherein said object to be processed is installed on a sample table provided in said vacuum chamber.
18. A fine-processing apparatus particularly as defined in 17, wherein said sample table is communicated with a cooling means for cooling said object to be processed to a predetermined temperature.
19. A fine-processing apparatus particularly as defined in 18, wherein said sample table is connected to a motor for rotating said sample table at a predetermined speed.

## Claims

1. A fine-processing apparatus using a low-energy neutral particle beam, comprising:
a plasma chamber for generating a high-density plasma therein;
an electrode for drawing out a low-energy ion beam from said plasma chamber;
a neutralizing chamber in which a reactive gas is introduced so as to contact said ion beam to neutralize said ion beam through charge exchange and produce a neutral particle beam; and
regulating means for aligning the direction of motion of said neutral particle beam produced in said neutralizing chamber toward an object to be processed.

2. A fine-processing apparatus according to Claim 1, wherein said high-density plasma is generated by hot-filament discharge, hollow cathode discharge, LaB₆ cathode discharge, high-frequency discharge, or microwave discharge.

3. A fine-processing apparatus according to Claim 2, wherein a space potential of said plasma generated in said plasma chamber is about several tens of volt.

4. A fine-processing apparatus according to Claim 2, wherein said plasma is generated by discharging a halogencontaining reactive gas or an inert gas supplied into said plasma chamber.

5. A fine-processing apparatus according to Claim 1, wherein said reactive gas is a halogen-containing gas.

6. A fine-processing apparatus according to Claim 1, wherein the energy level of said neutral particle beam is less than 100 eV.

7. A fine-processing apparatus according to Claim 5, wherein said fine processing is an etching which is effected by assist of bombardment with said low-energy neutral particle beam simultaneously with a reaction of said halogen-containing reactive gas adsorbed on the surface of said object to be processed.

8. A fine-processing apparatus according to Claim 1, wherein said drawing out electrode is provided at the outlet of said plasma chamber and is placed at negative potential.

9. A fine-processing apparatus according to any of the claims 1-wherein said drawing out electrode is a disc-shaped electrode including a number of pores,
wherein preferably a shielding electrode for shielding said plasma within said plasma chamber is provided inside of said drawing out electrode at the outlet of said plasma chamber,
wherein preferably wherein said shielding electrode is an electrically floating electrode,
wherein preferably wherein said shielding electrode is a disc-shaped electrode including a number of pores,
wherein preferably wherein said regulating means is an electrode provided outside of said drawing out electrode at the outlet of said plasma chamber, and said neutralizing chamber is defined between said drawing out electrode and said regulating electrode,
wherein preferably wherein said regulating electrode is maintained at the ground potential,
wherein preferably wherein said regulating electrode is a disc-shaped electrode including a number of pores,
wherein preferably wherein said object to be processed is installed in a vacuum container provided adjacent to said neutralizing chamber,
wherein preferably wherein said object to be processed is installed on a sample table provided in said vacuum chamber,
wherein preferably wherein said sample table is communicated with a cooling means for cooling said object to be processed to a predetermined temperature, and
wherein preferably wherein said sample table is connected to a motor for rotating said sample table at a predetermined speed.

10. A fine-processing apparatus using a particle beam, comprising:
a plasma chamber for generating a plasma therein;
an electrode for drawing out ion beam; and
a neutralizing chamber to produce a neutral particle beam.
